(19) **Europäisches Patentamt European Patent Office Office européen des brevets**

(11) **EP 0 901 229 B1**

(12) **EUROPEAN PATENT SPECIFICATION**

(45) Date of publication and mention
of the grant of the patent:
**06.06.2007 Bulletin 2007/23**

(51) Int Cl.:
*H03K 17/96* (2006.01)   *G06K 11/06* (2006.01)

(21) Application number: **98202853.2**

(22) Date of filing: **27.08.1998**

(54) **Electrically operable device operation**

Betrieb einer elektrisch bedienbaren Vorrichtung

Commande d'un dispositif à fonctionnement électrique

(84) Designated Contracting States:
**DE FR IT SE**

(30) Priority: **04.09.1997 GB 9718677**

(43) Date of publication of application:
**10.03.1999 Bulletin 1999/10**

(73) Proprietor: **Delphi Technologies, Inc.
Troy, MI 48007 (US)**

(72) Inventor: **Oel, Ludger
59590 Geseke (DE)**

(74) Representative: **Denton, Michael John
Delphi European Headquarters,
64 avenue de la Plaine de France,
Paris Nord II,
BP 60059, Tremblay-en-France
95972 Roissy Charles de Gaulle Cédex (FR)**

(56) References cited:
EP-A- 0 388 346          EP-A- 0 489 344
EP-A- 0 638 508          US-A- 4 543 562
US-A- 5 638 060

# Description

## Technical Field

The present invention relates to a system for operating an electrically operable device, and to a method of operating an electrically operable device using the system of the present invention.

## Background of the Invention

Current systems for operating electrically operable devices include conventional switches, and touchscreen systems based on capacitive, ultrasonic or optical technology. EP-A-0638508 describes a system in accordance with the preamble of claim 1.

## Summary of the Invention

It is an object of the present invention to provide an alternative system for operating an electrically operable device.

A system for operating an electrically operable device in accordance with the present invention is characterized over ET-A-0638508 by the features specified in the characterising portion of Claim 1.

The present invention also includes a method of operating an electrically operable device using the system of the present invention comprising the steps of measuring any change in force sensed by the force sensors; determining the position of the application of the force on the force responsive means dependent on the measured force change; operating the electrically operable device dependent on the determined force application position; and providing a signal indicating operation of the electrically operable device.

The present invention provides a new arrangement for controlling the operation of electrically operable devices.

## Brief Description of the Drawings

The present invention will now be described, by way of example, with reference to the accompanying drawings, in which:-

Figure 1 is an exploded view of a system in accordance with the present invention showing two alternative force responsive panels;
Figure 2 is a cross-sectional view through one of the rotatable actuators of Figure 1;
Figure 3 is a cross-sectional view through one of the pushable actuators of Figure 1;
Figure 4 is an illustration of the principle of the present invention; and
Figures 5 to 8 are partial cross-sectional views of alternative arrangements for providing vibration to the force responsive panel of Figure 1 to confirm operation of an electrically operable device.

## Description of the Preferred Embodiment

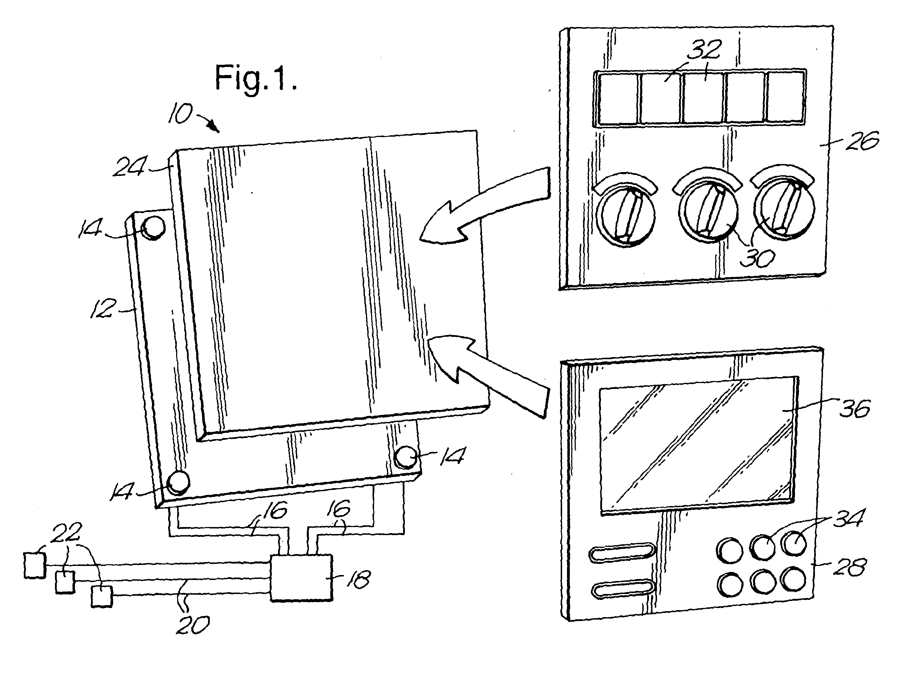

Referring to Figure 1, the system 10 of the present invention comprises a support panel or frame 12 which is substantially rectangular with a force sensor 14 mounted in each corner of the support frame. Each force sensor 14 is connected by lines 16 to an electronic control unit 18 which is connected by lines 20 to electrically operable devices 22. A force responsive panel 24 is mounted in engagement with the force sensors 14. The force responsive panel 24 may be any suitable arrangement. Two arrangements 26,28 for the force responsive panel 24 are shown in Figure 1. The first panel 26 comprises a number of manually rotatable actuators 30 and a number of manually pushable actuators 32, both of which are described in more detail below. The force responsive panel 28 comprises a number of manually pushable actuators 34 (which are substantially the same as the pushable actuators 32) and a touch screen device 36, which may be a glass panel positioned over a screen. Any suitable combination of rotatable and pushable actuators and touch screen devices may be used in the force responsive panel 24 of the present invention.

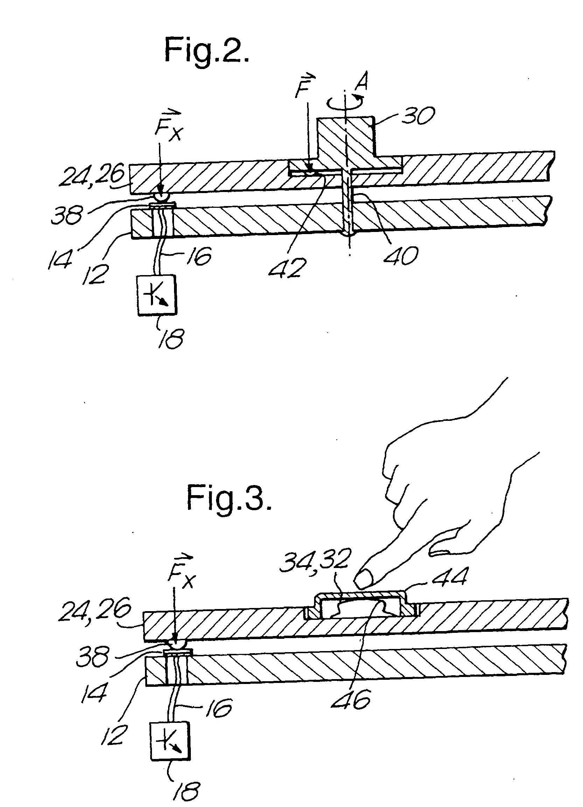

As shown in Figure 2, the force responsive panel 24,26 has a button 38, or any other suitable force transmitting device, in contact with each force sensor 14. Also, each rotatable actuator 30 has a spindle 40 which is rotatably mounted in the support frame 12 and defines the rotation axis A for the actuator 30. Offset from the rotation axis A, and in contact with the force responsive panel 24,26, the rotatable actuator 30 has a button 42. As the actuator 30 is rotated about axis A, the contact point between the button 42 on the actuator and the force responsive panel 24,26 transverses an arc of a circle. As shown in Figure 3, each pushable actuator 32 has a depressible cover 44 which is biased by a spring 46. Other suitable arrangements for the pushable actuator may be used.

The electronic control unit 18 is a computer based system which is programmed to calculate certain parameters based on received signals, and to send signals to operate the electrically operable devices 22 dependent on the calculated parameters. The electronic control unit 18 is also programmed with certain predetermined parameters such as the distance between the force sensors 14, and the positions of the actuators 30,32 relative to the force sensors. Each actuator 30,32 and/or each position on the touch screen device 36 relates to one or more of the electrically operable devices 22 and how that device or those devices is/are to be operated.

The electronic control unit 18 monitors the force signal from each force sensor 14. If one of the rotatable actuators 30 is manually rotated, the button 42 on the actuator moves relative to the force responsive panel 24,26. As a consequence of this movement, the force exerted on each force sensor 14 by the force responsive panel 24,26 changes. From the changing force signal from each force sensor 14, the electronic control unit 18 calculates the new position of the moved button 42. The electronic control unit 18 is therefore able to determine which of the rotatable actuators 30 has been moved, and which position it has been moved to. From this determination, the electronic control unit 18 sends an appropriate signal to one or more of the electrically operable devices 22 to operate the device or devices in accordance with the manually selected requirement. Similarly, if one of the pushable actuators 32 is manually depressed, the force exerted by the force responsive panel 24,26 on each force sensor 14 changes. From the changing force signal from the force sensors 14, the electronic control unit 18 calculates the position of the actuator 32 which has been depressed. The electronic control unit 18 is therefore able to determine which of the pushable actuators 32 has been depressed, and from this determination, the electronic control unit 18 sends an appropriate signal to one or more of the electrically operable devices 22 to operate the device or devices in accordance with the manually selected requirement. The electronic control unit 18 can be used in the same manner where the force responsive panel 28 has the touch screen device 36. Manual application of a force at a selected point on the touch screen device 36 will change the force being applied by the force responsive panel 28 on the force sensors 14. From the changing force signal from the force sensors 14, the electronic control unit 18 calculates the position of the application of manual force on the touch screen device 36, and operates the appropriate electrically operable device 22 according to the manually selected requirement.

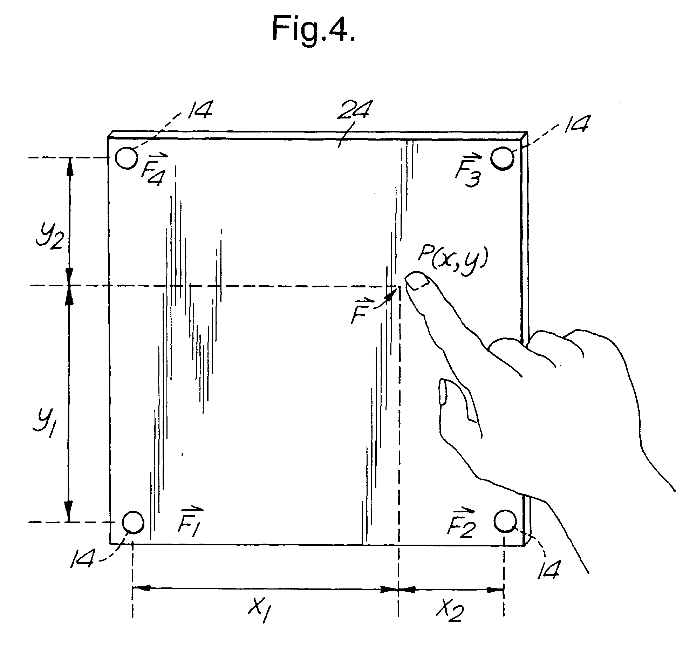

The basic principal of the present invention is shown in Figure 4. Application of a force F at a point P (x,y) on the force responsive panel 24 will change the force on the first force sensor 14 by $F_1$, on the second force sensor by $F_2$, on the third force sensor by $F_3$, and on the fourth force sensor by $F_4$. From the following equations:-

$$(F_1 + F_4)/F = x_2/(x_1 + x_2)$$

$$(F_1 + F_2)/F = y_2/(y_1 + y_2)$$

$$(F_2 + F_3)/F = x_1(x_1 + x_2)$$

$$(F_3 + F_4)/F = y_1/(y_1 + y_2)$$

the values of $x_1$, $x_2$, $y_1$, and $y_2$ can be calculated, and hence the position P(x,y) can be determined. The present invention works by sensing the application of a force to a force responsive panel 24 within an area bounded by the force sensors 14.

The electronic control unit 18 may also monitor the status of one or more of the electrically operable devices 22. For example, the first force application to a pushable actuator 32,34 may indicate that an electrically operable device 22 is to be switched on, and the second, subsequent, push on the same actuator will indicate that the same device is to be switched off.

The electronic control unit 18 may be programmed to monitor the speed of the change in force on each force sensor 14, or the absolute value of the applied force F. This arrangement can be used determining the amount of operation of one of the electrically operable devices 22 (for example, the required speed of an electric motor, temperature setting), or for detecting emergency situations.

The pushable actuator 32 may have include a spring 46, as mentioned above, which provides a form of feel or feedback to the operator that the actuator has been actuated. Such a feel or feedback is not available with the touch screen device 36. Also, it may not be apparent to the operator that the electronic control unit 18 has received the signal to actuate one of the electrically operable devices 22 as requested by the operator's manual actuation of one of the actuators 30-34 or the touch screen device 36. To overcome this potential problem, the electronic control unit 18 may also be capable of sending signals to a visual or audio device (not shown) to confirm operation of an electrically operable device 22. In a preferred arrangement, however, the electronic control unit 18, on sending a signal to one or more of the electrically operable devices 22, substantially simultaneously actuates a device (as described below) which vibrates the force responsive panel 24,26,28 for a predetermined amount of time. The vibration of the force responsive panel 24,26,28 will be felt by the operator to provide an indication that the electronic control unit 18 has actuated the electrically operable device 22 as required by the operator.

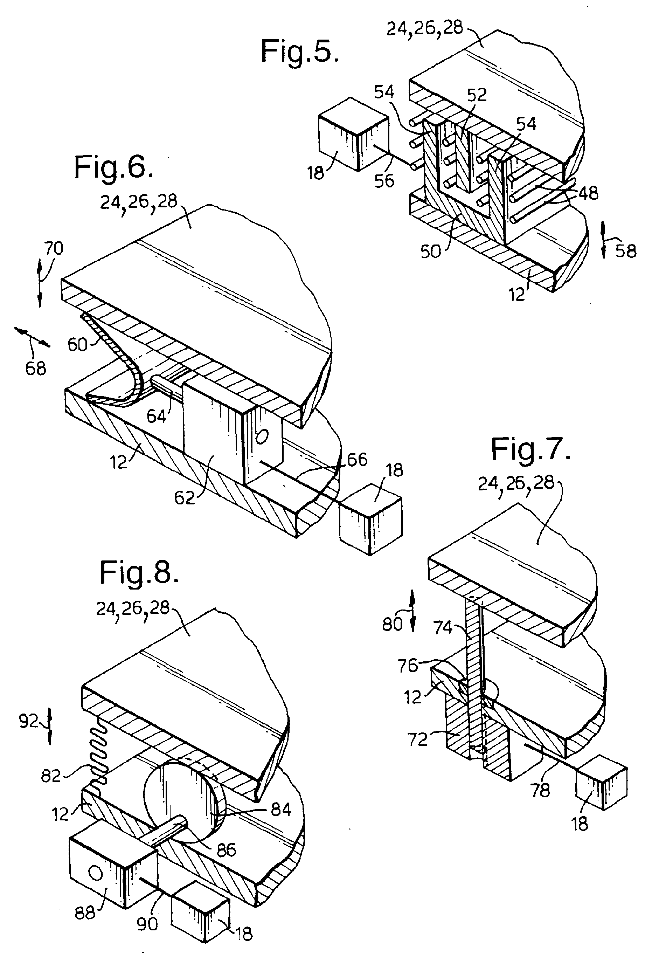

Examples of devices for vibrating the force responsive panel 24,26,28 are shown in Figures 5 to 8. In Figure 5, a coil 48 is positioned around a U-shaped core 50 secured to the support frame 12 or some other support member, and a magnetically responsive leg 52 is secured to the force responsive panel 24,26,28 and positioned between the arms 54 of the core 50. The coil 48 is connected by a line 56 to the electronic control unit 18. On sending a signal to one or more electrically operable devices 22, the electronic control unit 18 also sends a signal to the coil 48, causing the leg 52 to vibrate in the direction of arrow 58, and hence causing the force responsive panel 24,26,28 to vibrate. In Figure 6, a V- or U-shaped leaf spring 60 is secured between the force responsive panel 24,26,28 and the support frame 12 or other support member. A solenoid or other electromagnetic device 62 with a shaft 64 capable of translational movement is secured to the support frame 12. The solenoid 62 is connected by a line 66 to the electronic control unit 18. The shaft 64 is connected to a central portion of the leaf spring 60. On sending a signal to one or more electrically operable devices 22, the electronic control unit 18 also sends a signal to the solenoid 62, causing the shaft 64 to vibrate in the direction of arrow 68, and hence causing the force responsive panel 24,26,28 to vibrate in the direction of arrow 70. In Figure 7, a solenoid or other electromagnetic device 72 is mounted on the support frame 12 and has a shaft 74 which passes through a bearing 76 on the support frame and is secured to the force responsive panel 24,26,28. The solenoid 72 is connected by a line 78 to the electronic control unit 18. On sending a signal to one or more electrically operable devices 22, the electronic control unit 18 also sends a signal to the solenoid 72, causing the shaft 74 to vibrate in the direction of arrow 80, and hence causing the force responsive panel 24,26,28 to vibrate. In Figure 8, a coil spring 82 is secured between the force responsive panel 24,26,28 and the support frame 12. A rotatable cam member 84 is positioned between, and engageable with, the force responsive panel 24,26,28 and the support frame 12. The cam member 84 is connected off-centre to a shaft 86 which is rotatable by a DC motor 88. The DC motor 88 is connected by a line 90 to the electronic control unit 18. On sending a signal to one or more electrically operable devices 22, the electronic control unit 18 also sends a signal to the DC motor 88, causing the shaft 86 and the cam member 84 to rotate, and hence causing the force responsive panel 24,26,28 to vibrate in the direction of arrow 92.

In the present invention, any suitable number of force sensors 14 may be used. Also, the support frame 12 and the force responsive panel 24 may be any suitable shape.

The present invention has particular application in motor vehicles, and the force responsive panel 24 could, for example, be mounted in the dashboard of a motor vehicle, and be used for operating any one or more electrically operable devices, such as internal and external lights, windshield wipers, air conditioning fans, audio equipment, etc. In such an arrangement, the support panel or frame 12 could be provided by the dashboard.

## Claims

1.   A system for operating an electrically operable device (22) comprising support means (12); a number of force sensors (14) mounted on the support means; force responsive means (24-28); manually actuable means (30-36) acting on the force responsive means and actuable to alter the force exerted on the force sensors by the force responsive means; measuring means (18) for measuring any change in force sensed by the force sensors due to manual actuation of the manually actuable means; determining means (18) for determining the position of the force application on the force responsive means due to manual actuation of the manually actuable means from the measured force change; operating means (18) for operating the electrically operable device dependent on the determined position of the force application; and means (18,48-54) for providing a signal indicating operation of the electrically operable device; **characterised in that** the force responsive means (24-28) is in engagement with the force sensors; and **in that** the manually actuable means comprises an actuator (30) which is manually rotatable about an axis (A), the actuator having a button (42) which is offset from the rotation axis and in contact with the force responsive means (26).

2.   A system as claimed in Claim 1, wherein the manually actuable means further comprises a manually pushable actuator (32,34).

3.   A system as claimed in Claim 1, wherein the manually actuable means further comprises a touch screen device (36).

4.   A system as claimed in any one of Claims 1 to 3, wherein the force responsive means (24-28) has a button (38) in contact with each force sensor (14).

5.   A system as claimed in any one of Claims 1 to 4, further comprising means (18) for monitoring the rate of change of the force sensed by the force sensors and/or the absolute value of the applied force; and means (18) for operating the electrically operable device (22) dependent on the monitored rate of force change or the absolute value of the applied force.

6.   A system as claimed in any one of Claims 1 to 5, wherein the support means is a rectangular panel or frame (12), and wherein a force sensor (14) is mounted in each corner of the panel or frame.

7.   A system as claimed in any one of Claims 1 to 6, wherein the means for providing a signal indicating operation of the electrically operable device (22) comprises vibrating means (48-54) connected to the force responsive means (24-28) and causing vibration of the force responsive means when an electrically operable device is operated.

8.   A system as claimed in Claim 7, wherein the vibrating means comprises an electromagnetic device (48,50; 62;72) and a member (52,64,74) capable of translational movement by the electromagnetic device.

9.   A system as claimed in Claim 7, wherein the vibrating means comprises a DC motor (88) and a cam member (84) capable of rotational movement by the DC motor.

10. A system as claimed in any one of Claims 1 to 9 for use in a motor vehicle.

11. A method of operating an electrically operable device (22) using a system as claimed in any one of Claims 1 to 10, comprising the steps of
measuring any change in force sensed by the force sensors (14);
determining the position of the application of the force on the force responsive means (24-28) dependent on the measured force change;
operating the electrically operable device dependent on the determined force application position; and
providing a signal indicating operation of the electrically operable device.

**Patentansprüche**

1. System zum Betreiben einer elektrisch betreibbaren Vorrichtung (22), das umfasst: Unterstützungsmittel (12); eine Anzahl von Kraftsensoren (14), die an den Unterstützungsmitteln angebracht sind; kraftempfindliche Mittel (24-28); manuell betätigbare Mittel (30-36), die auf die kraftempfindlichen Mittel einwirken und betätigbar sind, um die durch die kraftempfindlichen Mittel auf die Kraftsensoren ausgeübte Kraft zu verändern; Messmittel (18) zum Messen jeglicher Änderung der durch die Kraftsensoren erfassten Kraft auf Grund der manuellen Betätigung der manuell betätigbaren Mittel; Bestimmungsmittel (18) zum Bestimmen der Position der Kraftausübung auf die kraftempfindlichen Mittel auf Grund der manuellen Betätigung der manuell betätigbaren Mittel anhand der gemessenen Kraftänderung; Betriebsmittel (18) zum Betreiben der elektrisch betreibbaren Vorrichtung in Abhängigkeit von der bestimmten Position der Kraftausübung; und Mittel (18, 48-54) zum Bereitstellen eines den Betrieb der elektrisch betreibbaren Vorrichtung angebenden Signals, **dadurch gekennzeichnet, dass** die kraftempimdlichen Mittel (24-28) mit den Kraftsensoren in Eingriff sind; und dass die manuell betätigbaren Mittel einen Aktor (30) umfassen, der um eine Achse (A) manuell drehbar ist, wobei der Aktor einen Knopf (42) besitzt, der von der Drehachse versetzt und mit den kraftempfindlichen Mitteln (26) in Kontakt ist.

2. System nach Anspruch 1, bei dem die manuell betätigbaren Mittel ferner einen manuell schiebbaren Aktor (32, 34) umfassen.

3. System nach Anspruch 1, bei dem die manuell betätigbaren Mittel ferner eine Berührungsschirmvorrichtung (36) umfassen.

4. System nach einem der Ansprüche 1 bis 3, bei dem die kraftempfindlichen Mittel (24-28) einen mit jedem Kraftsensor (14) in Kontakt befindlichen Knopf (38) besitzen.

5. System nach einem der Ansprüche 1 bis 4, das ferner Mittel (18) zum Überwachen der Änderungsrate der von den Kraftsensoren erfassten Kraft und/oder des Absolutwerts der ausgeübten Kraft; und Mittel (18) zum Betreiben der elektrisch betreibbaren Vorrichtung (22) in Abhängigkeit von der überwachten Rate der Kraftänderung oder des Absolutwerts der ausgeübten Kraft umfasst.

6. System nach einem der Ansprüche 1 bis 5, bei dem die Unterstützungsmittel eine rechtwinklige Platte oder ein rechtwinkliger Rahmen (12) sind und bei dem in jeder Ecke der Platte oder des Rahmens ein Kraftsensor (14) angebracht ist.

7. System nach einem der Ansprüche 1 bis 6, bei dem die Mittel zum Bereitstellen eines einen Betrieb der elektrisch betreibbaren Vorrichtung (22) angebenden Signals Vibrationsmittel (48-54) umfassen, die mit den kraftempfindlichen Mitteln (24-28) verbunden sind und eine Vibration der kraftempfindlichen Mittel hervorrufen, wenn die elektrisch betreibbare Vorrichtung betrieben wird.

8. System nach Anspruch 7, bei dem die Vibrationsmittel eine elektromagnetische Vorrichtung (48, 50; 62; 72) und ein Organ (52, 64, 74), das mittels der elektromagnetischen Vorrichtung eine translatorische Bewegung ausführen kann, umfassen.

9. System nach Anspruch 7, bei dem die Vibrationsmittel einen Gleichstrommotor (88) und ein Nockenelement (84), das mittels des Gleichstrommotors eine Drehbewegung ausführen kann, umfassen.

10. System nach einem der Ansprüche 1 bis 9 für die Verwendung in einem Kraftfahrzeug.

11. Verfahren zum Betreiben einer elektrisch betreibbaren Vorrichtung (22) unter Verwendung eines Systems nach einem der Ansprüche 1 bis 10, das die folgenden Schritte umfasst:

Messen jeglicher Änderung der durch die Kraftsensoren (14) erfassten Kraft;
Bestimmen der Position der Ausübung der Kraft auf die kraftempfindlichen Mittel (24-28) in Abhängigkeit von der gemessenen Kraftänderung;
Betreiben der elektrisch betreibbaren Vorrichtung in Abhängigkeit von der bestimmten Kraftausübungsposition; und
Bereitstellen eines Signals, das den Betrieb der elektrisch betreibbaren Vorrichtung angibt.

**Revendications**

1.  Système permettant de faire fonctionner un dispositif à fonctionnement électrique (22) comprenant des moyens de support (12) ; un certain nombre de capteurs de force (14) montés sur les moyens de support ; des moyens sensibles à la force (24-28) ; des moyens pouvant être actionnés à la main (30-36) agissant sur les moyens sensibles à la force et pouvant être actionnés pour modifier la force exercée sur les capteurs de force par les moyens sensibles à la force ; des moyens de mesure (18) pour mesurer une variation de force détectée par les capteurs de force due à un actionnement manuel des moyens pouvant être actionnés à la main ; des moyens de détermination (18) pour déterminer la position de l'application de la force sur les moyens sensibles à la force due à l'actionnement manuel des moyens pouvant être actionnés à la main par la variation de la force mesurée ; des moyens de fonctionnement (18) pour faire fonctionner le dispositif à fonctionnement électrique en fonction de la position déterminée de l'application de la force ; et des moyens (18, 48-54) pour fournir un signal indiquant le fonctionnement du dispositif à fonctionnement électrique ; **caractérisé en ce que** les moyens sensibles à la force (24-28) sont en prise avec les capteurs de force ; et **en ce que** les moyens pouvant être actionnés à la main comprennent un actionneur (30) qui peut être tourné à la main autour d'un axe (A), l'actionneur ayant un bouton (42) qui est décalé par rapport à l'axe de rotation et qui est en contact avec les moyens sensibles à la force (26).

2.  Système selon la revendication 1, dans lequel les moyens pouvant être actionnés à la main comprennent en outre un actionneur pouvant être enfoncé à la main (32, 34).

3.  Système selon la revendication 1, dans lequel les moyens pouvant être actionnés à la main comprennent en outre un dispositif à écran tactile (36).

4.  Système selon l'une quelconque des revendications 1 à 3, dans lequel les moyens sensibles à la force (24-28) ont un bouton (38) en contact avec chaque capteur de force (14).

5.  Système selon l'une quelconque des revendications 1 à 4, comprenant en outre des moyens (18) pour surveiller la cadence de variation de la force détectée par les capteurs de force et / ou de la valeur absolue de la force appliquée ; et des moyens (18) pour faire fonctionner le dispositif à fonctionnement électrique (22) en fonction de la cadence surveillée de la variation de la force ou de la valeur absolue de la force appliquée.

6.  Système selon l'une quelconque des revendications 1 à 5, dans lequel les moyens de support sont un panneau ou structure rectangulaire (12) et dans lequel un capteur de force (14) est monté à chaque angle du panneau ou structure.

7.  Système selon l'une quelconque des revendications 1 à 6, dans lequel les moyens pour fournir un signal indiquant le fonctionnement du dispositif à fonctionnement électrique (22) comprennent des moyens de vibration (48-54) connectés aux moyens sensibles à la force (24-28) et provoquant la vibration des moyens sensibles à la force quand un dispositif à fonctionnement électrique est activé.

8.  Système selon la revendication 7, dans lequel les moyens de vibration comprennent un dispositif électromagnétique (48, 50 ; 62 ; 72) et un élément (52, 64, 74) pouvant se déplacer en translation grâce au dispositif électromagnétique.

9.  Système selon la revendication 7, dans lequel les moyens de vibration comprennent un moteur à courant continu (88) et un élément de came (84) pouvant se déplacer en rotation grâce au moteur à courant continu.

10. Système selon l'une quelconque des revendications 1 à 9 à utiliser dans un véhicule à moteur.

11. Procédé de fonctionnement d'un dispositif à fonctionnement électrique (22) utilisant un système tel que revendiqué dans l'une quelconque des revendications 1 à 10, comprenant les étapes consistant à :

    mesurer toute variation de force détectée par les capteurs de force (14) ;
    déterminer la position de l'application de la force sur les moyens sensibles à la force (24-28) en fonction de la variation de force mesurée ;
    faire fonctionner le dispositif à fonctionnement électrique en fonction de la position d'application de la force déterminée ; et
    fournir un signal indiquant le fonctionnement du dispositif à fonctionnement électrique.

Fig.1.

# Fig.2.

# Fig.3.

# Fig.4.

Fig.5.

Fig.6.

Fig.7.

Fig.8.